# EUROPÄISCHE PATENTSCHRIFT

(11) **EP 0 901 317 B1**
(45) Veröffentlichungstag und Bekanntmachung des Hinweises auf die Patenterteilung: **14.05.2003**
(21) Anmeldenummer: 98114702.8
(22) Anmeldetag: 05.08.1998
(51) Int. Cl.: H05K 3/30

(54) **SMD-Tunerwanne**
Surface mounted electrical connector for tuner
Connecteur électrique monté en surface pour syntoniseur

(30) Priorität: 16.08.1997 DE 19735505
(43) Veröffentlichungstag der Anmeldung: 10.03.1999
(73) Patentinhaber: GRUNDIG Aktiengesellschaft, 90471 Nürnberg (DE)
(72) Erfinder: Krämer, Lars, 90471 Nürnberg (DE); Wetzstein, Manfred, 90471 Nürnberg (DE)

(56) Entgegenhaltungen:
- EP-A- 0 427 151
- DE-A- 3 637 190
- DE-C- 4 316 382
- GB-A- 2 270 206
- US-A- 4 814 944

## Beschreibung

Die Erfindung betrifft eine SMD-Tunerwanne, insbesondere für ein Fernsehgerät oder einen Videorecorder oder einen Satellitenreceiver oder ein Gerät der Unterhaltungselektronik, zur Aufnahme und Kontaktierung eines Standard-Tuners auf einer Kunststoffplatte mit Kupferkaschierung, insbesondere einer Leiterplatte.

Herkömmliche Bauteile eines Gerätes der Unterhaltungselektronik, zum Beispiel eines Standard-Tuners, sind in der Regel mit Anschlußkontakten ausgestattet, die in entsprechend den Anschlußkontakten vorgesehenen Lochungen einer Leiterplatte kontaktierbar sind. Die Montage eines Standard-Tuners ist lediglich auf einer konventionellen Leiterplatte möglich. Daneben sind sogenannte "MID-Bauteile" (**M**oulded **I**nterconnect **D**evices) bekannt, die auf einer entsprechenden MID-Leiterplatte angeordnet werden können.

Der Erfindung liegt die Aufgabe zu Grunde, eine Vorrichtung für einen Standardtuner anzugeben, welcher ohne großen Aufwand als MID-Bauteil auf einer entsprechenden Leiterplatte bestückt werden kann.

Diese Aufgabe wird durch eine Vorrichtung mit den in Anspruch 1 angegebenen Merkmalen gelöst. Vorteilhafte Ausgestaltungen und Weiterbildungen der Erfindung ergeben sich aus den abhängigen Ansprüchen.

Der Erfindung liegt die Erkenntnis zugrunde, daß ein Standard-Tuner mit konventionellen bedrahteten Anschlußpins für die Bestückung auf einer MID-Leiterplatte nicht geeignet ist. Auf überraschend einfache Weise kann ein im wesentlichen konventioneller Standard-Tuner zur Bestückung auf einer MID-Leiterplatte verwendet werden, wobei das Tunerhauptteil im wesentlichen aus einem konventionellen Standard-Tuner besteht, während die eigentliche Bestückung des Tuners auf der MID-Leiterplatte durch die SMD-Tunerwanne erfolgt. Die SMD-Tunerwanne dient einerseits der Aufnahme des Tunerhauptteils und andererseits der Kontaktierung der SMD-Tunerwanne bzw. des Tunerhauptteils mit der MID-Leiterplatte. Hierzu wird der Tuner in die SMD-Tunerwanne eingeführt und beispielsweise durch mechanische Vorrichtungen fixiert. Durch in die SMD-Tunerwanne eingepresste Kontakte werden die elektrischen Anschlußkontakte des Tuners mit der SMD-Tunerwanne kontaktiert. Die in der SMD-Tunerwanne angeordneten Kontakte wiederum sind derart geformt, daß sie auf der, der Leiterplatte zugewandten Seite, mit der Leiterplatte als MID-Bauteil bestückt werden können.

Eine einfache Fixierung der SMD-Tunerwanne und somit des Tuners auf der Leiterplatte kann dadurch sichergestellt werden, daß die SMD-Tunerwanne Rastnasen aufweist, die zum Einrasten im entsprechenden Anordnungsmuster der Rastnasen in der Leiterplatte angeordnete Ausnehmungen vorgesehen sind.

Eine sichere Kontaktierung der elektrischen Kontakte des Tunerhauptteils in der SMD-Tunerwanne wird dadurch gewährleistet, daß die in der SMD-Tunerwanne angeordneten Kontakte aus in die SMD-Tunerwanne eingepressten Federn gebildet werden.

Eine Bestückung der SMD-Tunerwanne auf der Leiterplatte wird dadurch erreicht, daß die Federn an der, der Leiterplatte zugewandten Seite, jeweils Kontaktflächen aufweisen, die zur Kontaktierung mit Kontaktstellen auf der Leiterplatte mittels einer leitenden Klebeschicht vorgesehen sind.

Im folgenden wird die Erfindung anhand der in den Figuren dargestellten Ausführungsbeispielen näher beschrieben und erläutert.

Es zeigen:
- Fig. 1: ein Ausführungsbeispiel einer SMD-Tunerwanne mit eingestecktem Standard-Tuner,
- Fig. 2: die in Fig. 1 dargestellte SMD-Tunerwanne mit eingestecktem Standard-Tuner, Ansicht von unten,
- Fig. 3: die in den Fig. 1 und 2 dargestellte SMD-Tunerwanne mit eingestecktem Standard-Tuner mit Sicht von der Seite,
- Fig. 4: ein Ausführungsbeispiel einer SMD-Tunerwanne,
- Fig. 5: die SMD-Tunerwanne mit in der SMD-Tunerwanne aufgenommenen Standard-Tuner und
- Fig. 6: eine Kontaktfeder.

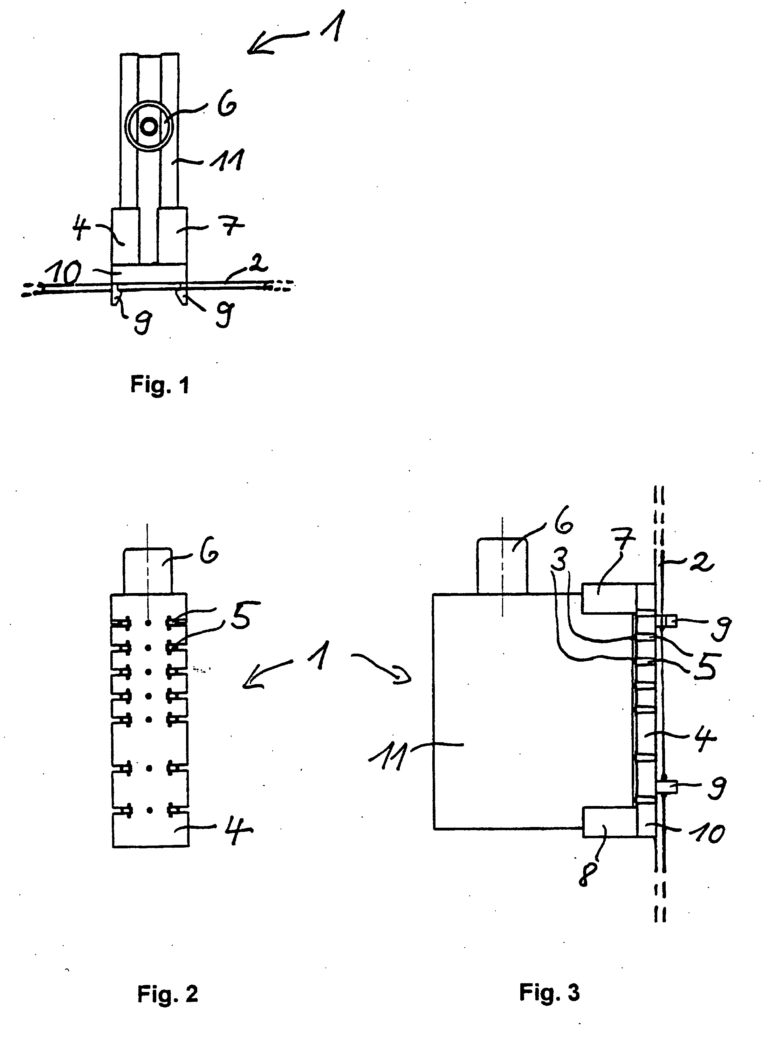

Fig. 1 zeigt ein Ausführungsbeispiel einer SMD-Tunerwanne 4. In die SMD-Tunerwanne 4 ist ein Standard-Tuner 1 eingesteckt. Der Standard-Tuner 1 besteht im wesentlichen aus einem Tunerhauptteil 11 mit einer Koaxialanschlußbuchse 6 zum Anschluß einer Antennenzuführung. In dem Tunerhauptteil 11 sind die zur Funktion des Standard-Tuners 1 benötigten Bauteile angeordnet. Die elektrische Verbindung des Tunerhauptteils 11 und einer Leiterplatte 2 erfolgt mittels einer SMD-Tunerwanne 4, die entsprechend den Abmessungen des Tunerhauptteils 11 ausgebildet ist und aus einem Unterteil 10 sowie aus seitlich angeordneten Stegen 7,8 gebildet wird. Im unteren Bereich des Gehäusebodens 10 der SMD-Tunerwanne 4 sind darüber hinaus Rastnasen 9 angeordnet, die zur Halterung der SMD-Tunerwanne 4 in der Leiterplatte 2 vorgesehen sind.
Zur Bestückung wird der Standard-Tuner 1, d.h. das Tunerhauptteil 11 in die SMD-Tunerwanne 4 eingeführt und dort durch geeignete mechanische Befestigungsmittel fixiert. Hierdurch werden die auf der, der Leiterplatte 2 zugewandten Seite, Anschlußkontakte des Standard-Tuners 1 mit in der SMD-Tunerwanne 4 angeordneten Kontakten 5 kontaktiert. Diese Kontakte 5 sind in vorteilhafter Weise als Kontaktfedern ausgebildet und besitzen am Ende, d.h. auf der, der Leiterplatte 2 zugewandten Seite, Kontaktflächen 16, die mit einer leitenden Klebeschicht eine Verbindung zur MID-Leiterplatte 2 herstellen.

Fig. 2 zeigt den in Fig. 1 dargestellten Standard-Tuner 1 von unten. Der Standard-Tuner 1 ist dabei in die SMD-Tunerwanne 4 eingeführt. Die SMD-Tunerwanne 4 weist Kontakte 5 auf, die zur Kontaktierung mit einer MID-Leiterplatte 2 vorgesehen sind. Aus Gründen der Übersichtlichkeit ist bei dem in Fig. 2 dargestellten Ausführungsbeispiel auf eine Darstellung der MID-Leiterplatte 2 verzichtet worden.

Fig. 3 zeigt den bereits im Zusammenhang mit den Fig. 1 und 2 dargestellten Standard-Tuner 1 in Seitenansicht. Dabei werden die bereits im Zusammenhang mit den Fig. 1 und 2 eingeführten Bezugszeichen verwendet. Der Standard-Tuner 1 besteht dabei im wesentlichen aus dem Tunerhauptteil 11 mit Koaxialanschlußbuchse 6. Im unteren Bereich, d.h. in dem der MID-Leiterplatte 2 zugewandten Bereich, weist das Tunerhauptteil 11 Kontakte 3 auf, die zur Kontaktierung mit an der SMD-Tunerwanne 4 angeordneten Kontakten 5 vorgesehen sind. Die Kontakte 5 sind in der SMD-Tunerwanne 4 derart angeordnet, daß sie sowohl der Kontaktierung mit den entsprechenden Anschlußkontakten des Tunerhauptteils 11, als auch zur Kontaktierung mit den entsprechenden Kontaktflächen der MID-Leiterplatte 2, insbesondere durch die Kontaktflächen 16 dienen.

Die Fig. 1 bis 3 zeigen ein Ausführungsbeispiel eines derartigen Standard-Tuners 1. Neben der gezeigten Ausführungsart sind auch Ausführungsbeispiele denkbar, wobei das Tunerhauptteil 11 beispielsweise selbst Rastnasen aufweist, die durch entsprechende Ausnehmungen der SMD-Tunerwanne 4 hindurch sowohl eine Fixierung des Tunerhauptteils 11 in der SMD-Tunerwanne 4 als auch eine Fixierung der gesamten Tuneranordnung 1, 4 auf einer MID-Leiterplatte 2 bewirken.

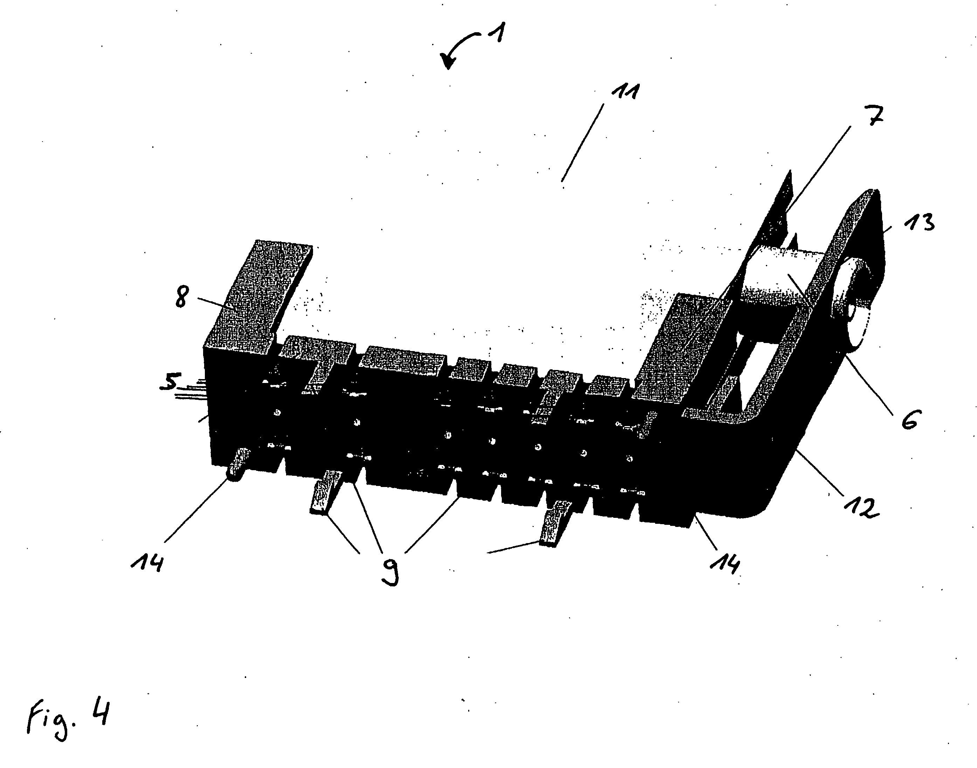

Fig. 4 zeigt eine plastische Darstellung der SMD-Tunerwanne 4 mit im Unterteil 10 eingepressten Kontaktfedern 5. Im weiteren sind die Stege 7, 8 am Unterteil 10 der SMD-Tunerwanne 4 angeordnet. Diese Stege 7, 8 dienen zum einen um dem eingesteckten Standard-Tuner 1 einen seitliche Halt und eine Führung in der SMD-Tunerwanne 4 zu geben. Im weiteren dienen die Stege 7, 8 dazu, beim Einsteckvorgang des Standard-Tuners 1 in die SMD-Tunerwanne 4 eine Führung zu gewähren, wodurch vermieden wird, daß sich der Standard-Tuner 1 beim Einführen in die SMD-Tunerwanne 4 verkantet und die Kontakte 3 beschädigt werden. Durch die Stege 7, 8 wird gewährleistet, daß der Standard-Tuner 1 stets ohne Verkantung in die SMD-Tunerwanne 4 eingeführt wird. Im weiteren ist ein Steg 12 an den Stegen 7 angeordnet, welcher in einem Winkel von 90° Grad gebogen ist und eine Öffnung 13 aufweist. Die Öffnung 13 ist in den Steg 12 derart eingebracht, daß die Koaxialanschlußbuchse 6 des Standard-Tuners 1 in der Öffnung 13 zu lagern kommt, wenn der Standard-Tuner 1 in der SMD-Tunerwanne 4 eingeschoben ist. Hierdurch wird die Koaxialanschlußbuchse 6 gestützt und auf den Standard-Tuner 1 über die Koaxialanschlußbuchse 6 wirkende Kräfte, insbesondere Drehmomente, von dem Steg 12 aufgenommen und somit kompensiert. Der Standard-Tuner 1 wird auf diese Weise von mechanischen Belastungen, z.B. beim Anschließen der Koaxialanschlußbuchse 6 entlastet.
Im weiteren sind an der SMD-Tunerwanne 4 Zapfen 14 vorhanden. In der MID-Leiterplatte 2 sind Bohrungen vorgesehen in welche die Zapfen 14 bei der Bestückung der MID-Leiterplatte 2 mit der SMD-Tunerwanne 4 einpassen.

Hierdurch wird eine genaue Positionierung der SMD-Tunerwanne 4 auf der MID-Leiterplatte 2 ermöglicht. Im weiteren dienen die Zapfen 14 als Schutz gegen ein Verdrehen.
Die SMD-Tunerwanne 4 ist aus ABS-Material hergestellt.

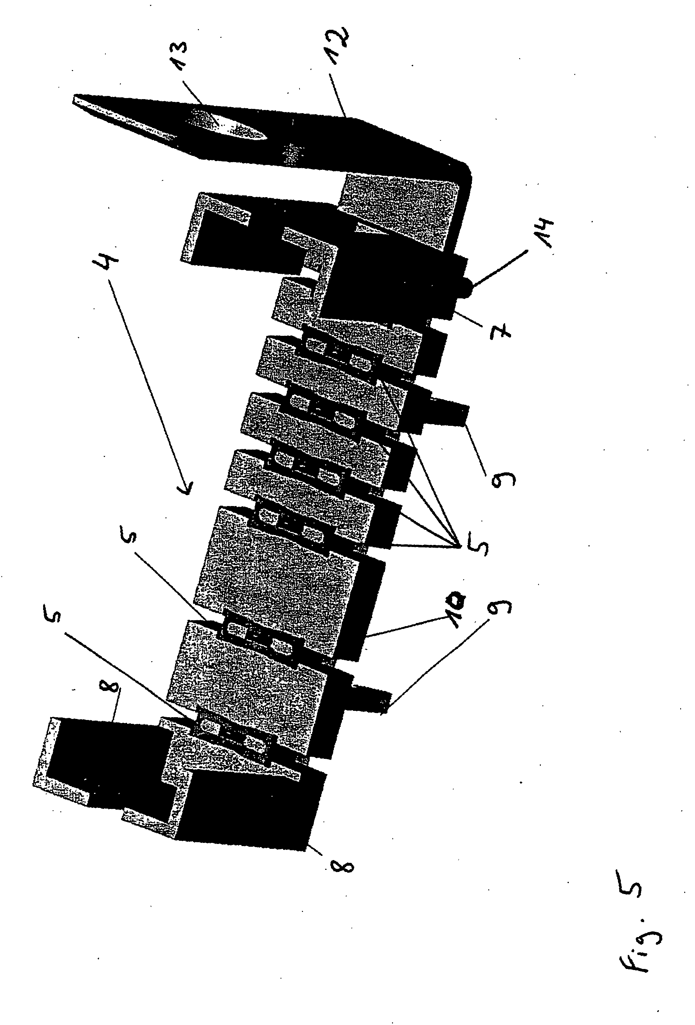

Fig. 5 zeigt eine plastische Darstellung der SMD-Tunerwanne 4 mit eingeschobenem Standard-Tuner 1. Rastnasen 9 an dem Unterteil 10 der SMD-Tunerwanne 4 sind derart ausgestaltet, daß sie beim Fixieren der SMD-Tunerwanne 4 auf der Leiterplatte 2 elastisch reagieren, d.h. auftretende Kraftspitzen kompensieren.

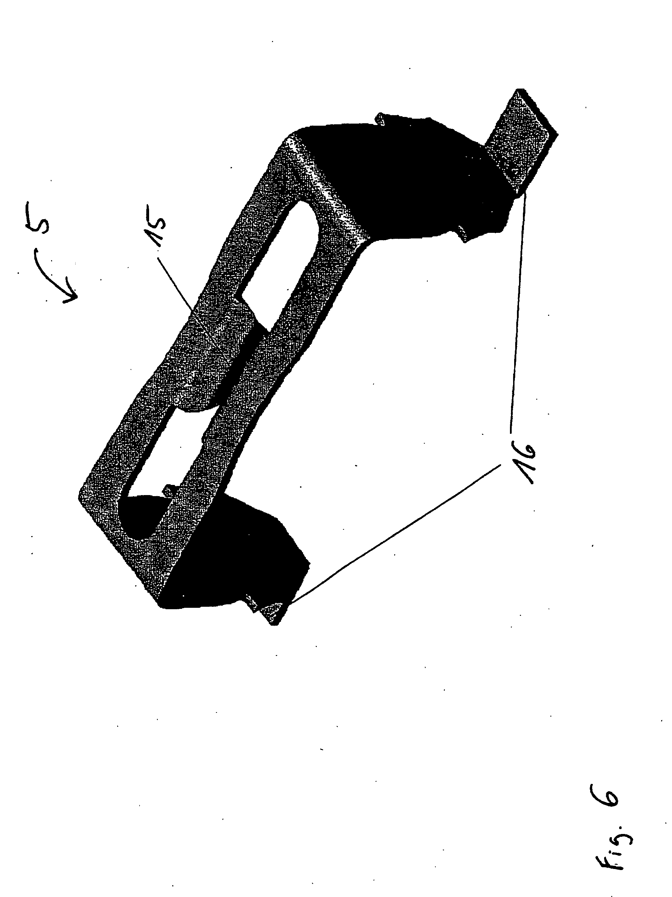

Fig. 6 zeigt eine Darstellung einer Ausgestaltungsform eines Kontaktes 5, welche in die SMD-Tunerwanne 4 eingepresst wird. Die Kontakte 5 sind als Federn ausgestaltet und weisen Konatkflächen 16 auf, welche zur Kontaktierung der SMD-Tunerwanne 4 und der MID-Leiterplatte 2 dienen. Die Federn 5 weisen im weiteren Federzungen 15 auf. Diese Federzungen 15 sind nach innen gebogen und dienen zur Aufnahme jeweils eines der Kontakte 3 des Standard-Tuners 1. Die Federzungen 15 sind derart gestaltet, daß sie beim Einschieben eines Kontaktes 3 des Standard-Tuners 1 nachgeben und den Kontakt 3 aufnehmen und formschlüssig umschließen.

## Patentansprüche

1. Vorrichtung (4) zur mechanischen und elektrischen Kontaktierung eines Tuners (1), insbesondere für ein Fernsehgerät oder einen Videorecorder oder einen Satellitenreceiver und zur mechanischen und elektrischen Verbindung des Tuners (1) mit einer Leiterplatte (2),
**dadurch gekennzeichnet, dass**
die Vorrichtung (4) Kontaktstellen (5) zur Kontaktierung des Tuners (1) aufweist, welche aus in die Vorrichtung (4) eingepressten Federn gebildet sind und die Leiterplatte (2) eine MID-Leiterplatte ist.

2. Vorrichtung (4) nach Anspruch 1,
**dadurch gekennzeichnet, dass**
die Vorrichtung (4) eine Tunerwanne ist.

3. Vorrichtung (4) nach Anspruch 2,
**dadurch gekennzeichnet, dass**
die Tunerwanne als SMD-Bauteil geführt ist.

4. Vorrichtung (4) nach einem oder mehreren der Ansprüche 1 bis 3,
**dadurch gekennzeichnet, dass**
die Vorrichtung (4) Rastnasen (9) aufweist, die zum Einrasten in entsprechend dem Anordnungsmuster der Rastnasen (9) in der Leitplatte (2) angeordneten Ausnehmungen vorgesehen sind.

5. Vorrichtung (4) nach einem oder mehreren der Ansprüche 1 bis 4,
**dadurch gekennzeichnet, dass**
die Federn (5) an der, der Leiterplatte (2) zugewandten Seite, jeweils Kontaktflächen (16) aufweisen, die zur Kontaktierung mit Kontaktstellen auf der Leiterplatte (2) mittels einer leitenden Klebeschicht versehen sind.

6. Vorrichtung (4) nach einem oder mehreren der Ansprüche 1 bis 5,
**dadurch gekennzeichnet, dass**
an der Vorrichtung (4) Stege (7, 8) angeordnet sind, welche als Führung für den Tuner (1) dienen.

7. Vorrichtung (4) nach einem oder mehreren der Ansprüche 1 bis 6,
**dadurch gekennzeichnet, dass**
die Vorrichtung (4) einen Steg (12) aufweist, welcher an dem Steg (7) angeordnet ist.

8. Vorrichtung (4) nach einem oder mehreren der Ansprüche 1 bis 7,
**dadurch gekennzeichnet, dass**
der Steg (12) eine Öffnung (13) enthält, in welcher die Koaxialanschlussbuchse (6) des Tuners (1) lagert, wenn die Vorrichtung (4) den Tuner (1) aufnimmt.

9. Vorrichtung (4) nach einem oder mehreren der Ansprüche 1 bis 8,
**dadurch gekennzeichnet, dass**
die Vorrichtung (4) aus ABS-Material gefertigt ist.

10. Vorrichtung (4) nach einem oder mehreren der Ansprüche 1 bis 9,
**dadurch gekennzeichnet, dass**
der Tuner (1) ein Standardtuner ist.

## Claims

1. Device (4) for making mechanical and electrical contact to a tuner (1), in particular for a television set or a video recorder or a satellite receiver, and for connecting the tuner (1) mechanically and electrically to a conductor board (2), **characterized in that** the device (4) has contact points (5) for making contact to the tuner (1) that are formed from springs pressed into the device (4) and the conductor board (2) is an MID conductor board.

2. Device (4) according to Claim 1, **characterized in that** the device (4) is a tuner holder.

3. Device (4) according to Claim 2, **characterized in that** the tuner holder is designed as an SMD component.

4. Device (4) according to one or more of Claims 1 to 3, **characterized in that** the device (4) has latching lugs (9) that are provided for latching in recesses disposed in the conductor board (2) to match the arrangement pattern of the latching lugs (9).

5. Device (4) according to one or more of Claims 1 to 4, **characterized in that** the springs (5) each have, on that side adjacent to the conductor board (2), contact faces (16) that are provided for making contact to contact points on the conductor board (2) by means of a conductive adhesive layer.

6. Device (4) according to one or more of Claims 1 to 5, **characterized in that** webs (7, 8) that serve as guidance for the tuner (1) are disposed on the device (4).

7. Device (4) according to one or more of Claims 1 to 6, **characterized in that** the device (4) has a web (12) that is disposed on the web (7).

8. Device (4) according to one or more of Claims 1 to 7, **characterized in that** the web (12) comprises an opening (13) in which the coaxial connecting socket (6) of the tuner (1) rests when the device (4) receives the tuner (1).

9. Device (4) according to one or more of Claims 1 to 8, **characterized in that** the device (4) is made of ABS material.

10. Device (4) according to one or more of Claims 1 to 9, **characterized in that** the tuner (1) is a standard tuner.

## Revendications

1. Dispositif (4) pour l'établissement d'un contact mécanique et électrique avec un syntoniseur (1), notamment pour un appareil de télévision ou un enregistreur vidéo ou un récepteur de satellite et pour l'établissement de la liaison mécanique électrique du syntoniseur (1) avec une plaquette à circuits imprimés (2), **caractérisé en ce que** le dispositif (4) comporte des zones de contact (5) pour l'établissement du contact avec le syntoniseur (1), qui sont formées par des ressorts insérés à force dans le dispositif (4), et que la plaquette à circuits imprimés (2) est une plaquette à circuits imprimés MID.

2. Dispositif (4) selon la revendication 1, **caractérisé en ce que** le dispositif (4) est un berceau de montage de syntoniseur.

3. Dispositif (4) selon la revendication 2, **caractérisé en ce que** le berceau de montage de syntoniseur est réalisé en tant que composant SMD.

4. Dispositif (4) selon une ou plusieurs des revendications 1 à 3, **caractérisé en ce que** le dispositif (4) comporte des becs d'encliquetage (8), qui sont destinés à s'encliqueter dans des évidements qui sont disposés dans la plaquette à circuits imprimés (2) de manière à correspondre au modèle de disposition des becs d'encliquetage (9).

5. Dispositif (4) selon une ou plusieurs des revendications 1 à 4, **caractérisé en ce que** les ressorts (5) comportent, sur le côté, qui est tourné vers la plaquette à circuits imprimés (2), des surfaces respectives de contact (16), qui sont destinées à établir un contact avec des zones de contact sur la plaquette à circuits imprimés (2) à l'aide d'une couche adhésive conductrice.

6. Dispositif (4) selon une ou plusieurs des revendications 1 à 5, **caractérisé en ce que** sur le dispositif (4) sont disposées des barrettes (7, 8), qui sont utilisées en tant que guide pour le syntoniseur (1).

7. Dispositif (4) selon une ou plusieurs des revendications 1 à 6, **caractérisé en ce que** le dispositif (4) possède une barrette (12), qui est montée sur la barrette (7).

8. Dispositif (4) selon une ou plusieurs des revendications 1 à 7, **caractérisé en ce que** la barrette (12) comporte une ouverture (13), dans laquelle est montée la douille de raccordement coaxiale (6) du syntoniseur (1), lorsque le dispositif (4) reçoit le syntoniseur (1).

9. Dispositif (4) selon une ou plusieurs des revendications 1 à 8, **caractérisé en ce que** le dispositif (4) est réalisé en un matériau ABS.

10. Dispositif (4) selon lune ou plusieurs des revendications 1 à 9, **caractérisé en ce que** le syntoniseur (1) est un syntoniseur standard.
